Europäisches Patentamt

European Patent Office

Office européen des brevets

(11) Publication number: **0 497 290 A2**

## EUROPEAN PATENT APPLICATION

(21) Application number: **92101387.6**

(22) Date of filing: **28.01.92**

(51) Int. Cl.⁵: **H01L 21/263**, H01L 21/329, H01L 29/90

(30) Priority: **28.01.91 JP 8725/91**

(43) Date of publication of application:
**05.08.92 Bulletin 92/32**

(84) Designated Contracting States:
**DE FR GB**

(71) Applicant: **KABUSHIKI KAISHA TOSHIBA
72, Horikawa-cho Saiwai-ku
Kawasaki-shi Kanagawa-ken Tokyo(JP)**

(72) Inventor: **Osawa, Akihiko
4-14-3, Haramachida
Machida-Shi, Tokyo-To(JP)**
Inventor: **Baba, Yoshiro
5-4-5, Sasage, Konan-Ku
Yokohama-Shi, Kanagawa-Ken(JP)**

(74) Representative: **Lehn, Werner, Dipl.-Ing. et al
Hoffmann, Eitle & Partner Patentanwälte
Arabellastrasse 4
W-8000 München 81(DE)**

(54) Switching semiconductor device and method of manufacturing the same.

(57) A method of manufacturing a switching semiconductor device including the steps of: forming an epitaxial layer (8) of one conductivity type on a semiconductor substrate (1) by means of an epitaxial growth method;

a second step of forming a semiconductor layer (4) of the other conductivity type opposite to the one conductivity type in the epitaxial layer (8) at near the surface thereof;

a third step of forming an electrode (6) on the semiconductor layer (4) using a field protective film (5); and

a fourth step of forming a high carrier (9) concentration region at the boundary region between the semiconductor substrate (1) and the epitaxial layer (8), by radiating charged particles.

FIG. 3

EP 0 497 290 A2

FIELD OF THE INVENTION

The present invention relates to a method of manufacturing a switching semiconductor device, and more particularly to a method of manufacturing a switching semiconductor device, suitable for use in manufacturing high speed switching elements.

BACKGROUND OF THE INVENTION

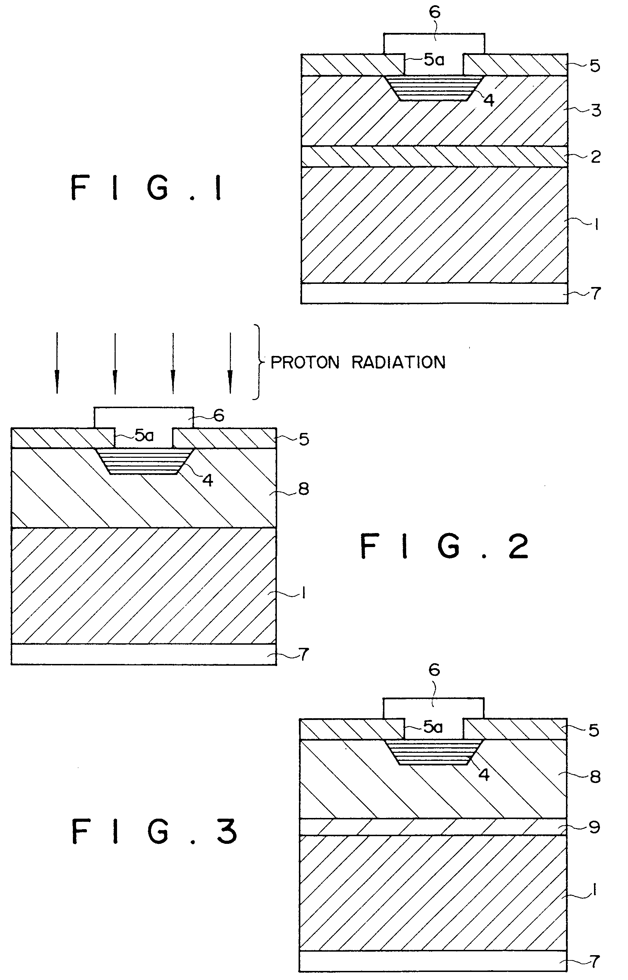

Fig. 1 is a cross sectional view of a general high speed switching diode. As shown in Fig. 1, this high speed switching diode includes a semiconductor substrate 1 placed on a bottom electrode 7. First and second epitaxial layers 2 and 3 are formed on this substrate 1. The first epitaxial layer 2 has a specific resistance of 1 $\Omega \cdot$cm and a thickness of 10 $\mu$m, and the second epitaxial layer has a specific resistance of 50 $\Omega \cdot$cm and a thickness of 70 $\mu$m. In the second epitaxial layer 3, a semiconductor layer 4 of an opposite conductivity type is grown. A field protective film 5 having an opening 5a is formed on the semiconductor layer 4, and an electrode 6 is connected to the layer 4. In order to improve a switching speed, an electron beam is radiated at 10 Mev and at a dose of $5 \times 10^{13}/cm^2$, and platinum is diffused.

Switching semiconductor devices have been manufactured by the method described above, which results in some problems of many manufacturing processes and a relatively low switching speed. High speed switching diodes are required to have a high surge voltage tolerance and a high switching speed. For this reason, three manufacturing processes are required, including a process of forming the first epitaxial layer, a process of radiating an electron beam, and a process of diffusing platinum. Moreover, electron beam radiation and platinum diffusion are required in order to control the life time of carriers. However, radiation of an electron beam to a semiconductor device may generate defects in the semiconductor device and raise an on-voltage. Therefore, a dose of electrons is limited, disabling to set a switching speed too high.

SUMMARY OF THE INVENTION

It is therefore an object of the present invention to manufacture a high speed switching semiconductor device with a small number of manufacturing steps. More particularly, it is an object of the present invention to manufacture a high speed switching semiconductor device with a small number of manufacturing steps, by radiating charged particles so as to generate defects at the pass region of the charged particles to shorten the life time of carriers and increase the carrier concentration at the stop region.

Charged particles are radiated to the epitaxial growth layer on the semiconductor substrate to form the high carrier concentration region between the Substrate and the epitaxial layer. The charged particles radiated by this process shorten the carrier life time at the proton pass region, and increase the carrier concentration at the proton stop region. Therefore, a manufactured switching semiconductor device has a considerably improved switching speed. Moreover, only one process (charged particles radiation process) is required instead of conventional three processes (epitaxial growth process, electron beam radiation process, and platinum diffusion process).

BRIEF DESCRIPTION OF THE DRAWINGS

Fig. 1 is a cross sectional view of a switching semiconductor device manufactured by a conventional method.

Fig. 2 is a schematic diagram showing a method of manufacturing a Switching semiconductor device according to an embodiment of the present invention.

Fig. 3 is a cross sectional view of a semiconductor device manufactured by the method of the present invention.

Fig. 4 is a graph showing a carrier concentration relative to a depth of a semiconductor substrate radiated with protons.

Fig. 5 is a graph showing a proton dose relative to a carrier concentration.

DESCRIPTION OF THE PREFERRED EMBODIMENT

An embodiment of the present invention will be described with reference to the accompanying drawings.

Fig. 2 is a schematic diagram showing a method of manufacturing a semiconductor device according to the embodiment of the present invention. As shown in Fig. 2, a semiconductor substrate 1 is placed on a bottom electrode 7. Grown on this substrate 1 is an epitaxial growth layer 8 having a specific resistance of 50 $\Omega \cdot$cm and a thickness of 80 $\mu$m. Within this epitaxial growth layer 8, a semiconductor layer 4 of an opposite conduction type is grown. Next, a field protective film 5 having an opening 5a is formed. Then, an electrode 6 is formed in contact with the layer 4 via the opening 5a. Protons as charged particles are radiated at an acceleration energy of 2.6 MeV and at a dose of 5 x $10^{13}$/cm². In this manner, a semiconductor device is manufactured.

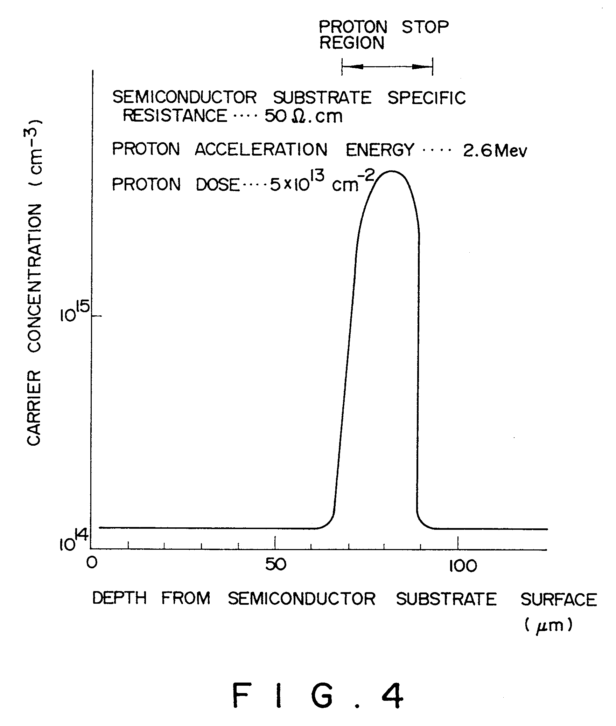

As shown in Fig. 4, proton radiation at an acceleration energy of 2.6 MeV provides a radiation range of about 80 $\mu$m within silicon. Accordingly, protons stop at the boundary region between the semiconductor substrate 1 and epitaxial growth layer 8. As seen from the cross section shown in Fig. 3, the carrier concentration increases at the proton stop region, forming a high carrier concentration region 9. After proton radiation, a thermal process is carried out in an N$_2$ atmosphere at 350°C and for 60 minutes.

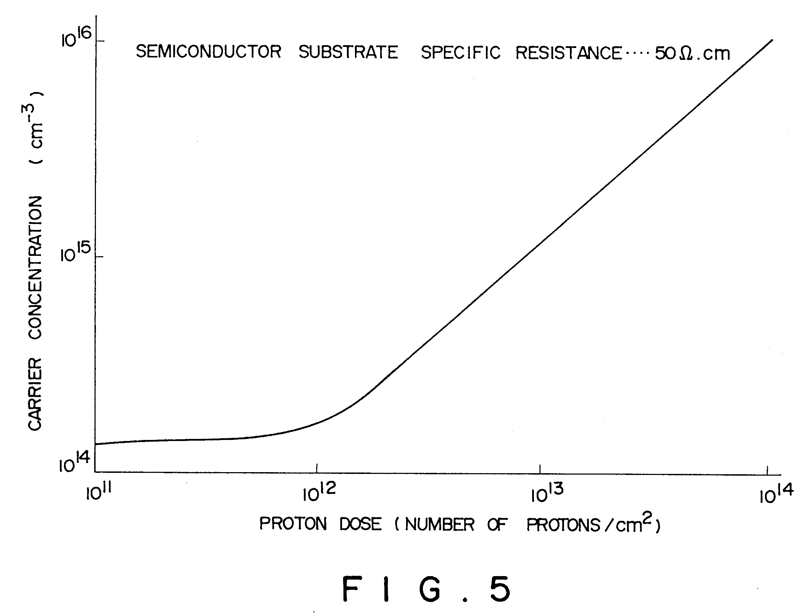

In a semiconductor device manufactured by the above-described processes, the carrier concentration considerably increases over the range in excess of a proton dose of 1 x $10^{12}$/cm², as shown in Fig. 5. At the dose of 4.8 x $10^{13}$/cm², the carrier concentration at the proton stop region is 4.8 x $10^{15}$/cm$^{-3}$ which is substantially the same as the carrier concentration of 7 x $10^{15}$/cm$^{-3}$ of the conventional first epitaxial growth layer 2. Therefore, even the device structure shown in Fig. 3 can have a sufficient surge voltage tolerance. Defects within the proton pass region are generated at the region deeper than that generated by electron beam radiation, and the detect level density generated by proton radiation is greater than electron beam radiation by one digit or more. As a result, the carrier life time is shortened at the proton pass region, allowing to manufacture a high speed switching semiconductor device.

Furthermore, as shown in Table 1, a device manufactured by the present invention method has a higher switching speed and smaller on-voltage, than those of a device manufactured by the conventional method.

Table 1

|  | Switching Speed | On-voltage |
|---|---|---|
| Device of Conventional Method | 112 nsec | 2.5 v |
| Device of Invention Method | 55 nsec | 2 V |

The conventional method requires an epitaxial growth process, electron beam radiation process, and platinum diffusion process. In contrast, the embodiment method replaces the three processes by only one process of proton radiation. As a result, the number of manufacturing steps and the number of manufacture days can be greatly reduced.

As the charged particles, heavy hydrogen ions or helium ions may be used.

**Claims**

1. A method of manufacturing a switching semiconductor device comprising:

   a first step of forming an epitaxial layer of one conductivity type on a semiconductor substrate by means of an epitaxial growth method;

   a second step of forming a semiconductor layer of the other conductivity type opposite to said one conductivity type in said epitaxial layer at near the surface thereof;

   a third step of forming an electrode on said semiconductor layer via a field protective film; and

   a fourth step of forming a high carrier concentration region at the boundary region between said semiconductor substrate and said epitaxial layer, by radiating charged particles.

2. A method according to claim 1, wherein protons are used as said charged particles.

3. A method according to claim 1, wherein ones of heavy hydrogen ions and helium ions are used as said charged particles.

4. A method according to any one of claims 1 to 3, wherein a dose of said charged particles is equal to or more than 1 x $10^{11}$/cm².

5. A method according to claim 2, wherein said field protective film has an opening at the position above said semi layer, and said electrode is in contact with said semiconductor layer via said opening.

**6.** A method according to claim 5, wherein said epitaxial layer has a specific resistance of 50 $\Omega \cdot$cm and a thickness of 80 $\mu$m, and said charged particles are radiated at an acceleration energy of 2.6 MeV and at a dose of 5 x $10^{13}$/cm$^2$.

**7.** A method according to claim 8, wherein after said charged particles radiation, a thermal treatment is carried out in an N$_2$ atmosphere, at 350°C and for 60 minutes.

**8.** A method according to anyone of claims 1, 2 and 5 to 7, wherein said semiconductor substrate is placed on an electrode.

4

F I G . 1

F I G . 2

PROTON RADIATION

F I G . 3

PROTON STOP
REGION

CARRIER CONCENTRATION ( cm$^{-3}$ )

SEMICONDUCTOR SUBSTRATE SPECIFIC
RESISTANCE ···· 50 $\Omega$.cm

PROTON ACCELERATION ENERGY ···· 2.6Mev

PROTON DOSE ···· 5×10$^{13}$ cm$^{-2}$

$10^{15}$

$10^{14}$

0                                    50                                    100

DEPTH FROM SEMICONDUCTOR SUBSTRATE SURFACE
( $\mu$m )

F I G . 4

6

SEMICONDUCTOR SUBSTRATE SPECIFIC RESISTANCE····50 Ω.cm

CARRIER CONCENTRATION ( $cm^{-3}$ )

PROTON DOSE ( NUMBER OF PROTONS / $cm^2$ )

F I G . 5

EP 0 497 290 A2